(19) Europäisches Patentamt

European Patent Office

Office européen des brevets

(11) **EP 0 833 960 B2**

(12) **NEUE EUROPÄISCHE PATENTSCHRIFT**

(45) Veröffentlichungstag und Bekanntmachung des Hinweises auf die Entscheidung über den Einspruch:
**03.05.2006 Patentblatt 2006/18**

(45) Hinweis auf die Patenterteilung:
**30.08.2000 Patentblatt 2000/35**

(21) Anmeldenummer: **96915993.8**

(22) Anmeldetag: **04.06.1996**

(51) Int Cl.:
***C23C 16/26*** (2006.01)     ***F28F 13/18*** (2006.01)

(86) Internationale Anmeldenummer:
**PCT/DE1996/001022**

(87) Internationale Veröffentlichungsnummer:
**WO 1996/041901 (27.12.1996 Gazette 1996/56)**

(54) **VERWENDUNG VON PLASMAPOLYMER-SCHICHTEN IN STOFFTRANSPORT- ODER WÄRMETAUSCHERSYSTEMEN**

USE OF PLASMA POLYMER LAYER SEQUENCES AS FUNCTIONAL LAYERS IN MATERIAL TRANSPORT OR HEAT EXCHANGER SYSTEMS

UTILISATION DE COUCHES POLYMERES PLASMIQUES DANS DES SYSTEMES DE TRANSPORT DE MATIERES OU D'ECHANGEURS DE CHALEUR

(84) Benannte Vertragsstaaten:
**CH DE FR GB LI NL**

(30) Priorität: **12.06.1995 DE 19521344**

(43) Veröffentlichungstag der Anmeldung:
**08.04.1998 Patentblatt 1998/15**

(73) Patentinhaber: **Fraunhofer-Gesellschaft zur Förderung der angewandten Forschung e.V. 80686 München (DE)**

(72) Erfinder:
 • **GRISCHKE, Martin, Dr. D-38176 Wendeburg (DE)**
 • **LEIPERTZ, Alfred, Prof. Dr. D-91054 Erlangen (DE)**
 • **KOCH, Gerd, Dr.-Ing. D-44534 Lünen (DE)**

(74) Vertreter: **Pfenning, Meinig & Partner GbR Patent- und Rechtsanwälte Theresienhöhe 13 80339 München (DE)**

(56) Entgegenhaltungen:
**EP-A- 0 625 588          GB-A- 1 069 535**

 • **PATENT ABSTRACTS OF JAPAN vol. 015, no. 181 (C-0830), 9.Mai 1991 & JP,A,03 044485 (MATSUSHITA REFRIG CO LTD), 26.Februar 1991,**
 • **Augmentation of Film Condensation on the Outside of Horizontal Tubes, AIChE Journal 19, No. 3, Mai 1973, S. 636f**
 • **The Influence of Thermocapillary Flow on Heat Transfer in Film Condensation, Transactions of the ASME, Journal of Heat Transfer, Feb. 1973, S. 21-24**
 • **Dropwise Condensation of Steam on Ion Implanted Condenser Surfaces, Heat Recovery Systems & CHP 14, No. 5, 1994, S. 525-534**

EP 0 833 960 B2

**Beschreibung**

Die Erfindung betrifft die Verwendung von Plasmapolymer-Schichtenfolgen als Funktionsschichten in Kondensatoren, wodurch diese Funktionsflächen mit definiert einstellbarem Benetzungsverhalten aufweisen. Ihre Anwendung ist in vielen Bereichen, bei denen Stofftransport- oder Wärmeaustauschsysteme zum Einsatz kommen, vorteilhaft.

Die Zu-oder Abfuhr von Wärme ist für viele verfahrenstechnische industrielle Prozesse von zentraler Bedeutung. Bei der Wärmeübertragung ist die Nutzung von Phasenübergängen (Kondensation-Verdampfung) vorteilhaft, da damit sehr hohe Wärmestromdichten erreichbar sind. Dies wird am Vorgang der Kondensation näher erläutert.

Die Dampfverflüssigung erfolgt in den meisten technischen Kondensatoren als Filmkondensation. Um ca. eine Größenordnung läßt sich der Wärmeübergangskoeffizient erhöhen, wenn die Kondensation als Tropfenkondensation erfolgt. Um dieses zu erreichen, müssen die Flächen, auf denen die Kondensation erfolgt ein definiertes Benetzungsverhalten aufweisen, das sich durch sehr kleine Oberflächenenergien bzw. durch Randwinkel von >60° auszeichnet.

Es ist bekannt, daß die Grundvoraussetzungen für die Tropfenkondensation das Vorliegen von hydrophoben Oberflächen (niedriger Oberflächenenergie) im Kondensator ist. Die definierte Herstellung von Kondensatoroberflächen niedriger Oberflächenenergie erfordert den Einsatz spezifischer Beschichtungen auf den - aus Wärmeübertagungsgründen - erforderlichen Metallteilen.

Es ist weiter bekannt, daß monomolekulare Schichten auf der Basis von Langmuir-Blodgett-Filmen niedrige Oberflächenenergien aufweisen können. Die extrem geringe Dicke dieser Schichten und die geringen Möglichkeiten, deren mechanisch/korrosive Eigenschaften zu optimieren, machen diese für die Anwendung in technischen Kondensatoren aus Lebensdauergründen weitgehend ungeeignet.

Auch andere Schichten sind ungeeignet, falls diese den mechanisch/korrosiven Beanspruchungen nicht standhalten. Ist zur mechanisch/korrosiven Widerstandsfähigkeit der Schicht eine so große Schichtdicke erforderlich. daß der damit verbundene Wärmewiderstand insgesamtzu keiner Intensivierung der Wärmeübertragungsleistung führt (eventuell sogar zu einer Verschlechterung im Vergleich zu dem Ausgangssystem), dann ist diese Schicht ebenfalls ungeeignet.

Stoffe, die über physikalische und/oder chemische Effekte am metallischen Grundmaterial anhaften und für das Erreichen von unvollständiger Benetzung zu Untersuchungen der Tropfenkondensation eingesetzt wurden, sind organische Verbindungen mit hydrophoben Gruppen, verschiedene Kunststoffe, anorganische Substanzen, spezielle Legierungen und, nicht ohne Widersprüchlichkeiten verschiedener Ergebnisse, auch Edelmetalle. Die Tabelle 1 soll hierzu nur einige Referenzen darstellen.

Tabelle 1

| stellen den Promotereinsatz, wobei hier unter Promoter alle zur Hydrophobisierung des Basismaterials wirksam eingesetzten Substanzen verstanden werden, zum Herbeiführen von Tropfenkondensation (wesentliche Arbeiten, kein Anspruch auf Vollständigkeit) dar. Die hier bezifferten Literaturstellen sind der Aufstellung aus Anlage 1 zu entnehmen. | | |
| --- | --- | --- |
| **Stoff/Substanz** | **Anmerkungen** | **Referenz** |
| Organische Verbindungen | 37 unterschiedliche Verbindungen, 16 davon 500 Stunden getestet | Blackmann et al. (1) |
| | Montan Wax | Watson et al. (2) |
| | Montan Wax | Tanner et al. (3) |
| | Ölsäure | Finnicum u. Westwater (4) |
| | Silconöl | Mingdao und Jiliang (5) |
| | Unterschiedl. Promoter, Übersicht verschiedener Ergebnisse | Kast (6) |
| Polymere | Fluoroacrylic, Parylene, Emralon 333, Fluoroepoxy | Marto et al. (7) / Marto et al. (8) |
| | Polymerisierte Triazinedithiol-Filme auf Al/Mg Rohren | Mori et al. (9) |
| | PVC-Schichten | Haraguchi et al. (10) |
| | PTFE-Schicht | Utaka et al. (11) |
| | PTFE Benetzungsanalyse | Boyes und Ponter (12) |
| Anorganische Verbindungen | Sulfide und Selenverbindungen | Erb und Thelen (13) |
| | Galvanische Dispersionsschicht | Cluistra et al. (14) |

Tabelle fortgesetzt

| stellt den Promotereinsatz, wobei hier unter Promoter alle zur Hydrophobisierung des Basismaterials wirksam eingesetzten Substanzen verstanden werden, zum Herbeiführen von Tropfenkondensation (wesentliche Arbeiten, kein Anspruch auf Vollständigkeit) dar. Die hier bezifferten Literaturstellen sind der Aufstellung aus Anlage 1 zu entnehmen. | | |
| --- | --- | --- |
| **Stoff/Substanz** | **Anmerkungen** | **Referenz** |
| | speziell mit PTFE-Einlagerung | |
| Legierungen | Oberflächenlegierung, CU mit Cr, Fe, Al, Bi, Sb, Sn, Se, In | Zhang et al. (15) |
| | Ionenimplantation N, He, Ar, H | Zhao et al. (16) |
| | Ionenimplantation Cr, N in Cu | Zhao et al. (17) |
| Edelmetalle | Gold, hiemach sind reine Goldoberflächen vollständig benetzbar | Bemett und Zisman (18) und Smith (19) |
| | Gold mit Paraffin-thio-silan und Mercaptan | Wilkins et al. (20) |
| | Vergoldet, vakuumbeschichtet | Tanasawa und Westwater (21) |
| | Goldbeschichtungen, teils chemisch behandelt | Woodruff und Westwater (22) Barthau (23) |
| | Silber, elektroplattiert aufgebr. | O'Neill und Westwater (24) |

In den gesamten Untersuchungen der Tropfenkondensation bildet neben der Klärung rein wärmetechnischer Fragestellungen der Test denkbarer Promoter die Basis des Erreichens von Tropfenkondensation den Forschungsschwerpunkt.

Aus allen Forschungsergebnissen heraus, die indisputabel Möglichkeiten zum Erreichen von Tropfenkondensation aufzeigen, ist bis heute noch keine Methodik zur Anwendung im praktischen Kondensatorenbau gelangt. Dafür sind die noch unzureichenden Nachweise zur Standzeit von Promoterschichten und die damit fehlende Gewißheit einer langzeitigen Aufrechterhaltung der Tropfenkonden-sation verantwortlich.

Die EP 625588 A1 offenbart eine Plasmapolymer-Schichtenfolge als Hartstoffschicht auf Substraten, bei denen die Oberflächenenergie definiert eingestellt und darüber deren Adhäsionsverhalten gegenüber Kontaktpartnern kontrolliert werden kann. Gelehrt wird die Verwendung derartiger Hartstoffschichten als Schutzschicht im allgemeinen Maschinenbau, und dabei zum Beispiel auch als Schutzschicht auf Heizstäben wie beispielsweise von Waschmaschinen. Über einen möglichen Einsatz dieser Schichtenfolgen als Funktionsschicht in Stofftransport- bzw. Wärmetauschersystemen sagt diese Druckschrift nichts aus.

Die JP 3044485 A offenbart eine mit Fiuorgas behandelte Kohlenstoffschicht als geeignete Funktionsschicht für Wärmetauschersysteme. Die Behandlung mit Fluorgas ist jedoch verfahrensmäßig auf wenige Atomlagen der Kohlenstoffschicht beschränkt und zudem nicht langzeitstabil.

Die GB 1069535 A offenbart ein Verfahren zur Bereitstellung von mikroskopisch benachbarten, hydrophoben und hydrophilen Bereichen auf einem metallischen Wärmetransferelement, um den Wärmetransportkoeffizienten des derart präparierten Elements zu steigem. Diese Lösung verbessert das Sleden der eingesetzten Flüssigkeit. Eine Optimierung der Oberfläche für die Wärme- und/oder Stoffübertragung ist jedoch nicht vorgesehen. Dadurch ist das Verfahren gemäß GB 1069535 A beispielsweise für eine Verwendung Im Kondensatorbau nicht geeignet, da die Problematik der Kondensation mit diesem Verfahren nicht gelöst werden kann.

Es ist somit Aufgabe der Erfindung, Funktionsschichten der genannten Art zu finden, die in Kondensatoren, einsetzbar sind, die im Falle des Einsatzes auf Kondensatoren die Tropfenkondensation erzwingen und die im Anlagen- und Apparatebau vorteilhaft anwendbar sind.

Erfindungsgemäß wird diese Aufgabe mit der Verwendung einer Plasmapolymer-Schichtenfolge als Funktionsschlcht gemäß einem oder mehreren der Ansprüche 1 bis 4 gelöst.

Bei diesem Wärmetauschersystem mit definiert einstellbarem Benetzungsverhalten sind die Funktionsschichten, die auf das Grundmaterial der Funktionsflächen den aufgebracht sind, plasmamodifizierte Kohlenstoff-Wasserstoff-Schichten (a-C:H-Schichten oder DLC (Diamond-Like-Carbon)-Schichten). Diese plasmamodifizierten Kohlenstoff-Wasserstoff-Schichten bestehen aus iner Plasmapolymer-Schichtenfolge als Hartstoffschicht mit einer Oberschicht als Funktionsschicht sowie gegebenenfalls einer Zwischenschicht und einer Gradientenschicht, wobei die Oberschicht zur Einstellung eines definierten Benetzungsverhaltens neben den Basiselementen Kohlenstoff und Wasserstoff noch nichtmetallische bzw. halbmetallische Elemente der 3., 4., 5., 6. und/oder 7. Hauptgruppe des Periodensystems der Elemente (vorzugsweise zu 1 at% bis 70 at% bezogen auf den Kohlenstoffgehalt) enthält. Diese Schichten sind über herkömmliche PVD- oder CVD-Verfahren, z.B. einem Plasma-Enhanced-Chemical-Vapor-Deposition (PECVD)-Prozeß herstellbar. Diese Schichten sind an sich bekannt und in DE 44 17 235 A1, auch betreffs ihrer Herstellungsmöglichkeiten beschrieben.

Überraschenderweise wurde gefunden, daß in bestimmten Zusammensetzungsbereichen der Oberschicht diese Schichten als Funktionsschichten in bzw. auf folgenden Kondansatoren

- Plattenwärmeübertragern (Zusammensetzung der Oberschicht: 1-40 at% F, Si und/oder O, 60 - 99 at% C, Rest Wasserstoff bis max. 30 at%)
- Rohr- bzw. Rohrbündelwärmeübertragem (Zusammensetzung der Oberschicht: 1-40 at% F, Si und/oder O, 60 - 99 at% C, Rest Wasserstoff bis max. 30 at%)

hervorragend einsetzbar sind.

Die Unzulänglichkeiten des Standes der Technik können bei der Verwendung dieser speziell angepaßten Plasmapolymerschichten mit einstellbarem, definierten Benetzungsverhalten umgangen werden, da diese neben der geforderten hydrophoben Eigenschaft gleichzeitig eine extrem hohe Verschleißbeständigkeit und Lebensdauer aufweisen und dies bei Schichtdicken, die keinen signifikanten Wärmewiderstand aufweisen.

Bei den für den Einsatz als Funktionsschicht verwendeten Schichten handelt es sich um plasmamodifizierte amorphe Kohlenwasserstoffschichten (a-C:H-Schichten oder DLC-Schichten (Diamond-Like-Carbon)), die üblicherweise mittels eines Hochfrequenz-Plasmaprozesses im Vakuum aufgebracht werden. Es sind jedoch auch weitere Verfahren, wie beispielsweise die Puls-Plasmatechnik, die Mittelfrequenzanregung, Twin Mac-Verfahren, das Diodensputtern oder das Hohlkathodenverfahren und andere Verfahren, anwendbar. Amorphe Kohlenwasserstoff-Schichten können durch Einleiten von Acetylen in eine hochenergetische Glimmentladung (Plasma), die z.B. durch eine hochfrequente Einkopplung im MHz-Bereich aufrecht erhalten wird, auf verschiedensten Substraten aufgebracht werden. Dabei werden diese Schichten mit einer Rate von einigen mm/h abgeschieden. Die chemische Struktur der a-C:H-Schichten ähnelt der von hoch quervemetzten Polymeren, nur daß der Grad der Quervernetzung um ein vielfaches höher ist. Der Grad der Quervernetzung, und damit die Schichteigenschaften, können in einem gewissen Rahmen durch eine geeignete Prozeßführung beeinflußt werden. Chemisch bestehen reine amorphe Kohlenwasserstoff-Schichten nur aus Kohlenstoff und Wasserstoff, wobei ca. 70 - 95 Atomprozent Kohlenstoff (97 Gewichtsprozent) und 5-30 Atomprozent Wasserstoff in den Schichten typisch sind.

Die hohe Quervemetzung ist ursächlich für die chemische Stabilität der Schichten, sowie deren Resistenz gegen das Eindiffundieren reaktiver Komponenten, die zu einer Zerstörung des Grundwerkstoffes (Substrat) führen könnten. Grundsätzlich ist die Einsetzbarkeit des a-C:H-Schichtmaterials als Korrosionsschutzschicht aufgezeigt worden. Das a-C:H-Schichtsystem ist chemisch resistent gegen oxydierende und nicht oxydierende Säuren wie $HNO_3$ und HCl, gegen Laugen wie NaOH und gegen handelsübliche Lösungsmittel.

Im Vakuum abgeschiedene amorphe Kohlenwasserstoffe sind seit ca. 1975 als Schichtsystem bekannt. Unter Berücksichtigung geeigneter Substrate und deren Vorreinigung ist es grundsätzlich kein Problem, sowohl leitende, als auch isolierende Flächen zu beschichten. Dabei werden Schichtdicken im Bereich einiger mm abgeschieden, wobei die Wachstumsrate der Schichten bei einigen mm pro Stunde liegt. Ihren verbreitetsten Einsatz finden amorphe Kohlenwasserstoff-Schichten, häufig angereichert mit einer Metallkomponente, im tribologischen Bereich, wo sie zur Verschleiß- und Reibwertsminderung eingesetztwerden. Dabei werden, verglichen mit dem Verschleißverhalten von Stahl, Verbesserungen im Verschleißverhalten um den Faktor 100 erreicht.

Aufbauend auf der Basis der a-C:H-Schichten (DLC-Schichten) kann durch gezielten Einbau von weiteren Elementen in die hochvemetzte Kohlenwasserstoff-Matrix das Benetzungsverhalten gegen verschiedenste Lösungsmittel, Insbesondere aber gegen Wasser gezielt beeinflußt werden. So gelingt es, durch den Einbau von Fluor in die Schichten eine Oberfläche zu erzeugen, die in ihrem Benetzungsverhalten dem von Teflon[â] entspricht, wobei aber das sehr gute Verschleißverhalten der Schichten im wesentlichen beibehalten wird. Ähnliche Effekte lassen sich auch mit dem Modifizierungselement Silizium ereichen. Die Einstellbarkeit der Oberflächenenergie ist nicht absolut zu sehen, sondern kann im Gegenteil gezielt über den Fluor- bzw. Siliziumgehalt der Schichten eingestellt werden. Diese Eigenschaft der niedrigen Oberflächenenergie wird zur Erzwingung der Tropfenkondensation in Wärmeübertragersystemen ausgenutzt.

Während Fluor und Silizium die Oberflächenenergie deutlich absenken und somit zu einer geringeren Benetzung von Wasser führen, ist durch den Einbau von Elementen wie Stickstoff, Bor oder Sauerstoff der gegenteilige Effekt zu erreichen. Diese Elemente erhöhen deutlich die Oberflächenenergie einer beschichteten Oberfläche und führen zu einer deutlich verbesserten Benetzung von flüssigen Medien.

Neben der Modifizierung der gesamten Oberflächenenergie gelingt durch entsprechende Kombination von Modifizierungselementen auch die gezielte Beeinflussung der polaren und dispersen Oberflächenenergieanteile, die sich zur Gesamtoberflächenenergie addieren. Somit können Systeme für Ihren Einsatzfall optimal angepaßt werden.

Die Vorteile der Funktionsschichten ergeben sich daraus, daß durch ihre Verwendung in Kondensatoren Eigenschaften, wie z.B. einstellbares Benetzungsverhalten, Verschleißschutzfunktionen, Vermeidung eines korrosiven Angriffs und/oder der topographieerhaltenden Wirkung, auch in Kombination miteinander für Kondensatoren nutzber gemacht werden können.

An nachfolgenden Ausführungsbeispielen soll die Erfindung näher erläutert werden. In den Illustrationen werden dabei dargestellt:

| | |
|---|---|
| Bild 1 | Erscheinungsbild der Tropfenkondensation einer mit dem SICAN beschichteten Kupfer-Oberfläche, |
| Bild 2 | Schematische Darstellung des Grundaufbaus für wärmetechnische Messungen im Vorgang der Kondensation, |
| Bild 3 | Kondensatorscheibe mit Isolationsmantel (Maße in mm), |
| Bild 4 | Zusammenhang von Wärmestromdichte $\dot{q}$ und Wandunterkühlung (Wassersattdampf bei Umgebungsdruck p =1 bar) ermittelt aus den Versuchen, |
| Bild 5 | Erscheinungsbild der über Teilbeschichtung definiert erzwungenen Mischkondensation an der Scheibe TB7, |
| Bild 6 | Wärmestrom über Kühlwasservolumenstrom für die vollkommen beschichtete Scheibe und für unterschiedliche Teilbeschichtungen, gemessen mit Einzelstrahl und konstantem Wandabstand. |

**Beispiel 1**

Dieses Beispiel betrifft die Realisierung der Tropfenkondensation an Oberflächen durch den gezielten Einsatz einer Funktionsschicht bei Kondensatoren mit einer Funktionsfläche der Kondensatorwand aus unterschiedlichen Metallen bzw. Metallegierungen:

| | |
|---|---|
| <u>Funktionsschicht:</u> | **SICAN** (SICAN: Bezeichnung für die amorphe und modifizierte Kohlenwasserstoff-Schicht (a-C:H:Si)) Zusammensetzung: 32 at% Si, 67,5 at% C, 0,5 at% O, Rest Wasserstoff (wurde nicht bestimmt, aber bis 30 at% vorhanden) |
| <u>Herstellung der Funktionsschicht:</u> | 1. naßchemische Reinigung der Wärmetauscherfläche |
| | 2. Reinigung der Wärmetauscherfläche durch Plasmaätzen mit Argon (1.5 Pa, -1500V Bias, 50 sccm Ar) |
| | 3. Aufbringen einer 0,5 mm Haftschicht auf die Wärmetauscherfläche (1.5 Pa, -1200V Bias, 50 sccm Ar/Tetramethylsilan 1:1) |
| | 4. Aufbringen einer 2,5 mm Funktionsschicht auf die Wärmetauscherfläche (2 Pa, -800V Bias, 50 sccm Acethylen/Tetramethylsilan 10:2) |
| <u>Kondensierendes Medium:</u> | Reiner Wassersattdampf unter Umgebungsdruck |
| <u>Kondensatorwand:</u> | Ebene, senkrecht orientierte und kreisförmige Wand aus Kupfer, Aluminium, Messing und Stahl; die kondensatberührte Oberfläche ist beschichtet |
| <u>Wärmeaufnehmendes Medium:</u> | Wärmesenke über Kühlwasser konstanter Vorlauftemperatur in erzwungener Konvektion |

Die hier betrachtete Kondensation an Oberflächen ist der Übergang eines reinen Fluids vom dampfförmigen in den flüssigen Zustand. Bedingung zu diesem Phasenübergang ist eine Wandtemperatur, die niedriger als die über den Systemdruck bestimmte Sättigungstemperatur des angrenzenden Dampfes ist.

Die Kondensation an gekühlten Wänden kann in drei zu unterscheidenden Formen auftreten:

· Als Filmkondensation, wenn das Kondensat an der Wand einen zusammenhängenden Flüssigkeitsfilm ausbildet (Kondensat kann die Wand vollständig benetzen)

· Als Tropfenkondensation, wenn das Kondensat an der Wand in Form einzelner Tropfen entsteht (Kondensat kann die Wand nur unvollständig benetzen)

· Als Mischkondensation, wenn beispielsweise Dampfgemische kondensieren, deren flüssige Phasen unmischbar sind (Mischform aus Film- und Tropfenkondensation).

Bei den Erscheinungsformen der Kondensation hat das Phänomen der Tropfenkondensation die höchsten Wärmeübergangskoeffizienten.

Diese Kondensationsform kann praktiziert werden, falls die Kondensatorwand wirkungsvoll und dauerhaft für eine unvollständige Benetzbarkeit durch das Kondensat hergestellt ist. Die Werkstoffe für den Bau von Wärmeübertragungsapparaten sind fast ausschließlich metallischer Art und aufgrund ihrer hohen Oberflächenenergie durchweg gut benetzbar (Filmbildung). Die Tropfenkondensation soll durch geeignete, benetzungshemmende Wandbeschichtungen eingestellt werden.

Dieser Einsatz der SICAN-Schichten zum Erreichen von Tropfenkondensation wird in einem Versuchsstand im Kondensationsbetrieb mit Wassersattdampf bei Umgebungsdruck untersucht und die Leistungsfähigkeit der Wärmeübertragung aus Messungen ermittelt.

Die Tropfenkondensation wird heute als Keimbildungsprozeß verstanden.

Die ersten mikroskopisch kleinen Tropfen, die hier als Keimtropfen bezeichnet werden, bilden sich an ausgezeichneten Positionen auf der Kondensatorwand, an den Keimstellen. Dies sind Punkte besonderer Geometrie (Vertiefungen, Poren), lokal veränderter Benetzbarkeit oder einer Kombination von beiden.

Höchste Wärmeübergangskoeffizienten werden bei Tropfenkondensation erreicht, falls der Vorgang mit möglichst hohem Flächenanteil an kleinsten Tröpfchen vonstatten geht; diese Aussage ist den Modellvorstellungen gemeinsam.

Das Erscheinen von Tropfenkondensation setzt eingeschränkte Benetzungsfähigkeit der Wand durch das Kondensat voraus. Bestimmend für die Art der Wechselwirkung zwischen Wand und Fluid sind die Grenzflächen Flüssigkeit-Dampf (Gas), Festkörper-Flüssigkeit und Festkörper-Dampf.

Aus den Untersuchungen zur Tropfenkondensation können einzelne Punkte zu einem Anforderungsprofil an die Promoterschicht zusammengefaßt werden, damit diese, abgeschieden auf metallischen Wänden, günstige Bedingungen zur Verwirklichungen der Tropfenkondensation erreichen läßt:

A) Die Promoterschicht sollte eine möglichst geringe Oberflächenenergie der Kondensatorwand realisieren, damit sich das Kondensat in Tropfen mit großem Randwinkel bei gleichzeitig kleinster Randwinkelhysterese formiert.

B) Die Promoterschicht muß unter den Einsatzbedingungen eine stabile Wirkungsweise besitzen. Dazu gehört eine starke Haftung der Schicht am Basismaterial und auch eine hohe Korrosionsbeständigkeit, weil stoffliche und strukturelle Veränderungen der Oberfläche die Benetzbarkeit wesentlich beeinflussen.

C) Der Wärmewiderstand der notwendigen Promoterschicht darf in der Gesamtheit des Wärmedurchgangs nicht limitierend wirken, damit das Ziel, die gegenüber Filmkondensation höheren Wärmeübergangskoeffzienten zu nutzen, möglichst effektiv erreicht werden kann.

D) Die Herstellung und der Einsatz von Oberflächen für die Tropfenkondensation muß in Standzeit und wärmetechnischer Verbesserung wirtschaftlich, praktikabel und umweltverträglich sein.

Die Beschreibung der Leistungsfähigkeit eines Kondensationsphänomens ist durch die Angabe der übertragenen Wärmestromdichte q bei entsprechender Temperaturdifferenz zwischen Dampf und Kondensatoroberfläche eindeutig. Ein einzelner Vorgang ist dann effektiv, falls höchste Wärmestromdichten bereits bei geringer Temperaturdifferenz übertragen werden.

Analog gilt für die Beschreibung des Phasenwechselvorgangs das Newtonsche Abkühlungsgesetz.

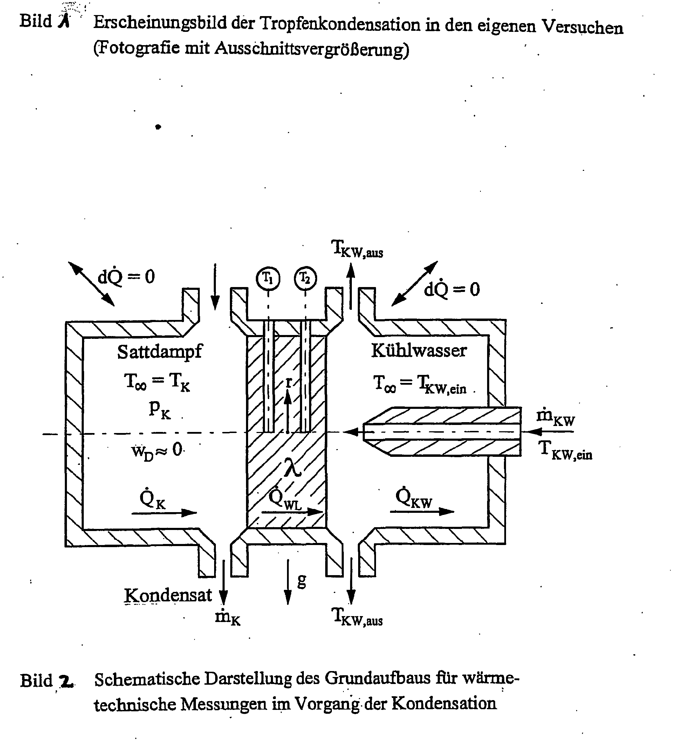

Das Bild 2 zeigt eine schematische Darstellung eines Grundaufbaus für Kondensationsmessungen an der ebenen und senkrecht orientierten Wand. Dieser Aufbau bildet die Grundlage zu den meßtechnischen Arbeiten, deren Ergebnisse hier dargestellt werden.

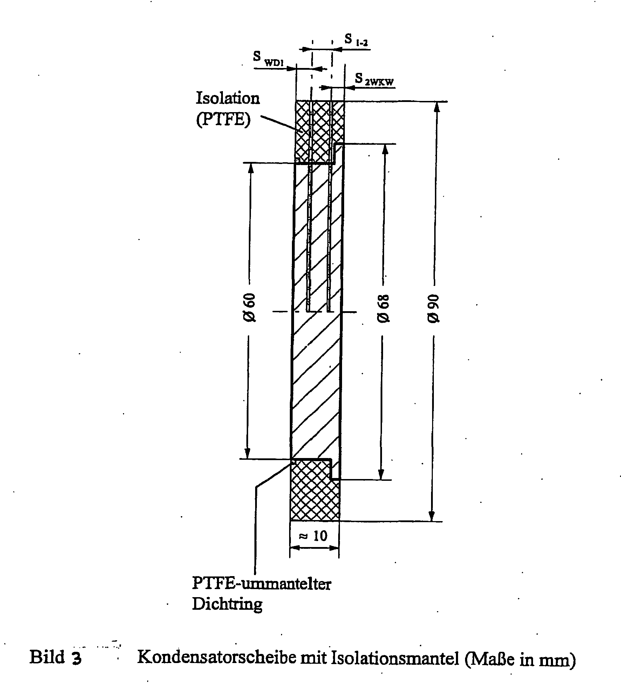

Die Geometrie der eingesetzten Kondensatorscheiben ist im Bild 3 ersichtlich. Die Beschichtung befindet sich auf der Seite mit 60 mm Durchmesser, an dieser Scheibenseite findet die Kondensation statt. Der Scheibenmantel ist mit einer dicken PTFE-Isolation verpackt, um hier unkontrollierte Wärmeströme zu unterdrücken.

In den Scheibenbohrungen wurde die Temperatur mit Thermoelementen (0 0,5 mm) gemessen. Die Eindimensionalität der Wärmeübertragung wird über den Vergleich der Wärmestromdichtebilanzen von Kondensat, Kühlwasser und Wärmeleitung beurteilt. Auf Details der Meßtechnik und zum Wesen einzelner Wärmeübergänge soll hier nicht eingegangen werden.

Die Leistungssteigerung, die bei Tropfenkondensation erreicht wird, kann über den Datenvergleich mit den Werten der üblichen Filmkondensation beurteilt werden.

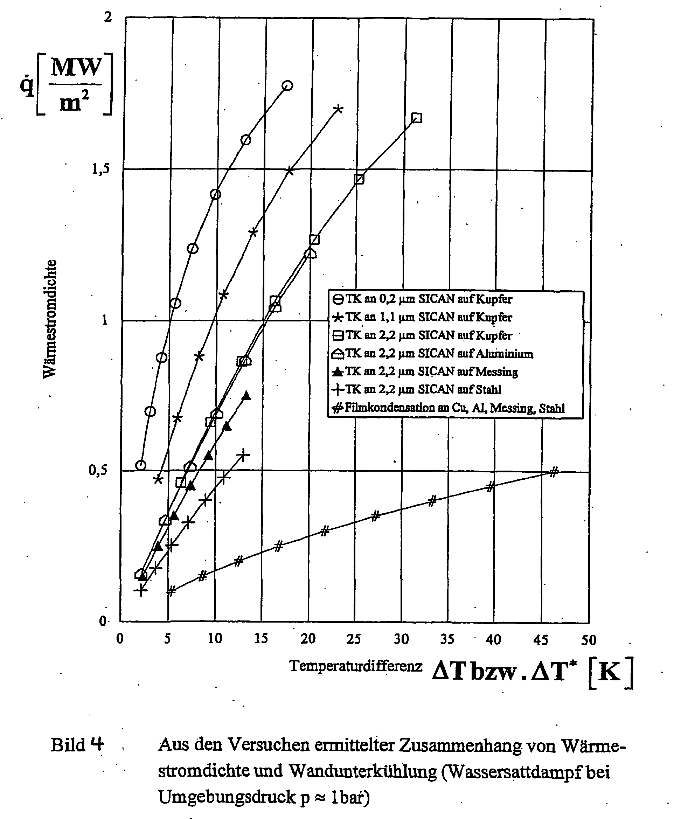

In Bild 4 zeigt sich die Leistungsstärke der Tropfenkondensation. Diese ist um so höher, je höher die Temperaturleitfähigkeit des Basismaterials ist und je dünner die Promoterschicht SICAN ist.

**Beispiel 2**

Das Beispiel 2 zeigt eine weitere technologisch und wirtschaftlich nutzbare Verbesserung, deren Basis der gezielte Einsatz von optimierten funktionellen Schichten und Schichtsystemen mit vorbestimmbarem Wirkungscharakter auf mechanisch stabile und gut wärmeleitenden Gründmateriallen (z.B. Metall)

anhand von Tellbeschichtungen auf Kupfer

In vielen Wärmeübertragungsvorgängen mit Filmkondensation, insbesondere dort wo dünne Wände hoher Wärmeleitfähigkeit und eine erzwungene konvektive Wärmeabfuhr in eine Flüssigkeitsströmung (Kühlwasser, turbulent strömend) eingesetzt werden, wirkt der Wärmewiderstand des Kondensatfilms leistungslimitierend auf den Gesamtvorgang (Wärmedurchgangskoeffizient). Aus diesem Grund sind Maßnahmen zur Leistungssteigerung zunächst hier anzusetzen. Die Erscheinung der Tropfenkondensation ist nicht an solch einen Widerstand gebunden. Hiermit wird der Gesamtvorgang der Wärmeübertragung bis ins Kühlwasser intensiviert.

Dabei stellt sich die Frage, ob nicht schon eine bereichsweise Minderung des kondensationsseitigen Wärmewiderstandes ausreichend ist, um dadurch eine Größenordnung zu erreichen, die dem nächstliegenden Wärmewiderstand (Kühlwasser oder Wand) gleichkommt. Damit würde bereits eine Intensivierung der gesamten Leistungscharakteristik erreicht. Weitere effektive Leistungssteigerungen ergeben sich nur durch die Reduzierung des limitierenden Wärmewiderstandes, der nun in der konvektiven Wärmeübertragung, wohl seltener in dem Wärmeleitvorgang vorhanden sein wird. Eine weitere Steigerung im Wärmeübergang mit Kondensation ist praktisch nur dann ein sinnvolles Ziel, falls zunächst der limitierende Wärmewiderstand der Wärmesenke oder des Wärmeleitvorganges reduziert wird. Eine derartige Behandlung des Wärmedurchgangs ist durch die Grundregel der Wärmeübertragung mit in Reihe geschalteten Widerständen gegeben: "Jeder einzelne Widerstand so gering wie möglich, aber der dazu nötige Aufwand nur so hoch wie nötig, um alle Wärmewiderstände in gleiche Größenordnung zu bringen".

Die Tabelle 2 zeigt die Ergebnisse der Randwinkeimessungen mit Reinstwasser in Laboratmosphäre (21°C, rel. Feuchte » 45%) mit durchweg 20 ml Tropfenvolumen als Mittelwerte über mehrere Messungen auf den kreisrunden Promoterbereichen, wobei sich die Prozentangabe in Tabelle 1 auf den prozentualen Anteil der für Tropfenkondensation beschichteten Fläche an der Gesamtfläche bezieht. Die Schichtbereiche sind kreisrunde Flächen mit einem Durchmesser von ca. 10 mm (TB7= 7 Schichtkreise, TB13 = 13 Schichtkreise und TB19 = 19 Schichtkreise auf der Kondensatorscheibe mit Durchmesser 60 mm).

Tabelle 2:

| Randwinkel an den mit Promoter beschichteten Bereichen | | | |
|---|---|---|---|
| Scheiben-Nr. | Basismaterial | Dicke der SICAN-Schicht | Ergebnis der Randwinkelmessung |
| TB 7 (19%) | Kupfer | 1,1 mm | im Schichtbereich 90° |
| TB 13 (36%) | Kupfer | 1,1 mm | im Schichtbereich 90° |
| TB 19 (53%) | Kupfer | 1,1 mm | im Schichtbereich 90° |

Die Aufbringung der SICAN-Schicht erfolgte wie bereits in Beispiel 1 beschrieben, wobei Bereiche, auf denen eine Beschichtung nicht erwünscht ist, maskiert wurden.

Die lokal erzwungene Tropfenkondensation bei gleichzeitiger Filmkondensation in der Nachbarschaft ist eine definierte Form der Mischkondensation. Da die Temperatur der Kondensatoroberfläche dabei lokal drastisch verschieden ist. kann über die Extrapolation einer punktuell im Festkörper gemessenen Temperatur keine mittlere Oberflächentemperatur ermittelt werden. Die Messungen zeigten hier auch die größten Schwankungen der Temperaturwerte der Scheibenfühler.

Aufschluß zur Wirkung von Teilbeschichtungen kann hier nur vergleichsweise mit der integralen Bilanzierung gewonnen werden.

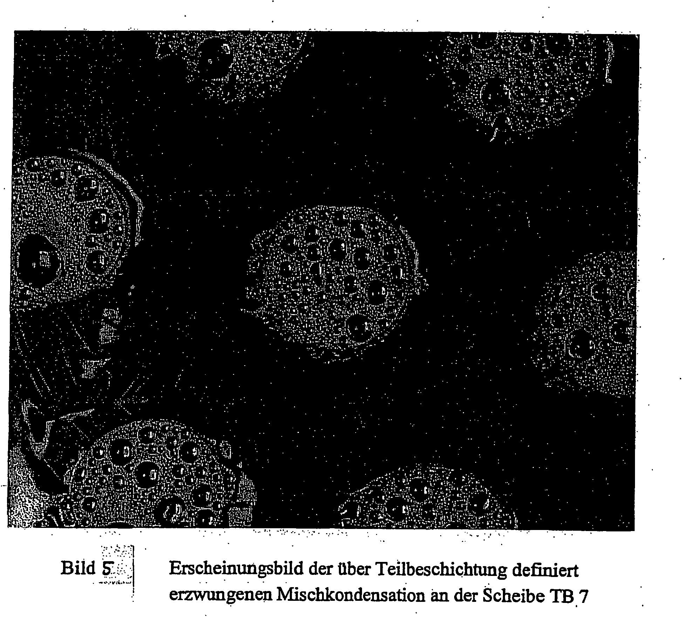

Im dunkleren Bildbereich von Bild 5 tritt Filmkondensation in Erscheinung. Der Film vermag es nicht in die vollständig benetzbaren Tropfenkondensationsbereiche überzutreten. Der Randbereich der Beschichtung wirkt als feste Barriere. Dies ist durchweg bis zu höchsten Kondensatmengen zu beobachten. Das im TK-Bereich entstehende Kondensat wird selbst entgegen der Schwerkraftwirkung in alle Richtungen in den Kondensatfilm transportiert.

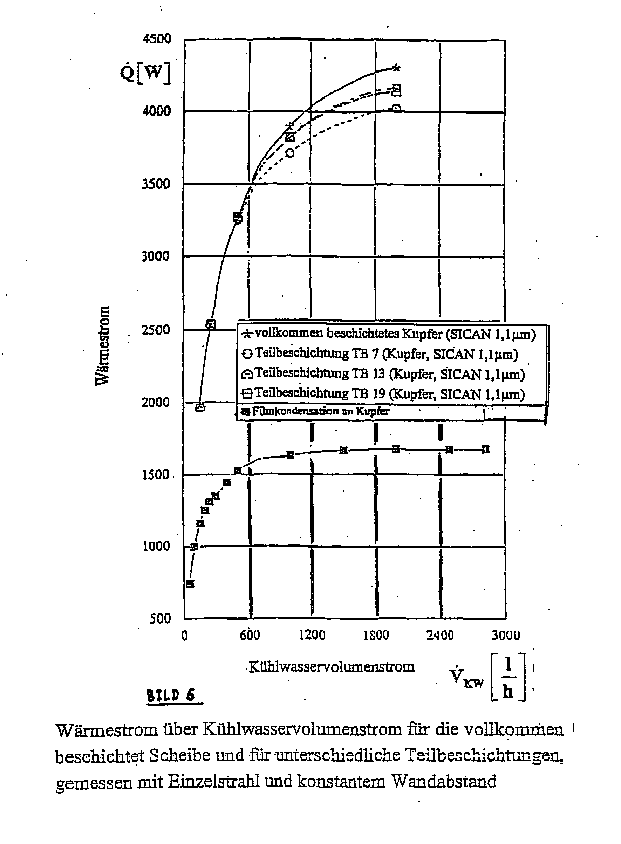

Das folgende Bild 6 zeigt vergleichsweise die Ergebnisse der integralen Bilanzierung in einer konstanten Apparatekonfiguration als Wärmestrom über eingesetztem Kühlwasservolumenstrom.

Auf die Darstellung der Unsicherheiten im Kühlwasservolumenstrom und im Wärmestrom wurde der Übersicht haiber verzichtet (Fehlerbanden zum Wärmestrom bewegen sich zwischen $\pm 0,9\%$ **(Q>4000W)** und $\pm 1.6\%$ **(Q<2000W).**

Bis zu einem gemessenen Kühlwasservolumenstrom von 500 l/h (dritter Meßpunkt) werden mit den Teilbeschichtungen gleich hohe Wärmeströme ermittelt, wie im Fall vollkommener Beschichtung. Erst bei sehr großem Kondensatanfall (Q>3500W) ist die vollkommene Beschichtung einer Teilbeschichtung überlegen.

Beobachtungen lassen erkennen, daß bei der Teilbeschichtung in den Zonen der Tropfenkondensation, gegenüber der vollflächigen Tropfenkondensation kürzere Zykluszeiten vorherrschen, damit ist die Zeit von Tropfentstehung über Tropfenwachstum bis zur Tropfendeplazierung zusammengefaßt. Es treten schnelle Tropfenbewegungen auf, die Kondensattropfen wandern in den Kondensatfilm hinein, sie werden vom Film "aufgesaugt". Mit diesen Beobachtungen und der wesentlichen Grundlagenerkenntnis, daß die integralen Leistungswerte durch eine Intensivierung der Kondensation nur dann gesteigert werden, falls kein weiterer Wärmewiderstand limitiert, ist die Gleichheit der integralen Leistungswerte aller Messungen in einem Betriebspunkt zu erklären. Erst bei großen Kühlwasservolumenströmen zeigt sich die verbesserte Leistungsfähigkeit der vollkommenen Beschichtung und die Werte der Teilbeschichtungen zeigen eine verbesserte Wirkung mit gesteigertem Beschichtungsanteil, also gesteigertem Anteil an Tropfenkondensation. Es ist somit eindeutig klar, daß die höchsten Wärmeübergangskoeffizienten mit reiner, vollkommener Tropfenkondensation erreicht werden und das eine Wechselwirkung zwischen Film- und Tropfenbereich nachweislich nicht dazu führen kann, die Effektivität der vollkommenen Tropfenkondensation zu übertreffen.

Mit Blick auf die praktische Anwendung der Tropfenkondensation, dies ist schließlich das übergeordnete Ziel, das durch die Übertragung aller einschlägiger Forschungsergebnisse letztlich erreicht werden soll, ist die Anwendung von Teilbeschichtungen effektiv möglich. Vergleichende Abschätzungen zeigen, daß wirtschaftlich erreichbare Wärmeübergangskoeffizienten der Wärmesenke mit der Versuchsanordnung bis zu einem Kühlwasservolumenstrom von 250 l/h nachempfunden sind (z.B. Kühlwasserströmung im Glattrohr, Strömungsgeschwindigkeiten bis zu 2,5 m/s). Hier ist für den Gesamtvorgang bereits eine Teilbeschichtung die auf 19 % der Oberfläche eine Tropfenkondensation erreichen läßt ebenso wirksam, wie eine vollkommene Beschichtung. Dies hat zwei Gesichtspunkte:

1. Für viele praktische Fälle kann bereits eine teilweise Tropfenkondensation effektiv genutzt werden. Selbstverständlich ist das nur dann sinnvoll, falls diese in der Realisierung gegenüber einer vollkommenen Beschichtung durch verbesserte Wirtschaftlichkeit ausgezeichnet ist. und

2. Die Ergebnisse können und sollten die Motivation zur Anwendung der Tropfenkondensation weiter stärken. Die wesentlichen Bedenken, die derzeit immer noch gegen die Anwendung der Tropfenkondensation sprechen sind für manche Lösungsansätze in der Tatsache, für manche Lösungsansätze in der Annahme begründet, daß die Vollkommenheit der Tropfenkondensation in einer vergleichsweise zur Lebensdauer des Apparates kurzen Zeit über das Auswachsen von Promoterdefekten verloren geht. Diese Bedenken können letztlich nur gesichert ausgeräumt werden, falls der Betriebsnachweis über die geforderte Lebensdauer geführt wird. Aus den Versuchsergebnissen darf abgeleitet werden, daß in vielen praktischen Fällen bis zu 80 % der Oberfläche in Filmkondensation umschlagen darf, ohne das merkliche Leistungseinbußen eintreten.

In der Versuchszeit mit Teilbeschichtungen (ca. 1 Woche je Scheibe) wurde an den künstlich geschaffenen Keimstellen für Defekte (Schichtrand) keine Schichtzerstörung beobachtet.

Anlage 1

**Aufstellung der Literaturstellen aus Tabelle 1**

[1] Blackmann, L. C. F., Dewar, M. J. S., Hampson, H.
An investigation of Compounds promoting the dropwise Condensation of steam
J. appl. Chem. 7, 160-171 (1957)
[2] Watson, R. G. H., Birt, D. C. P., Honour, C. W., Ash, B. W.
The Promotion of dropwise Condensation by Montan Wax
I. Heat Transfer Measurement
J. appl. Chem. 12, 539-546 (1962)
[3] Tanner, D. W., Poll, A., Potter, J., Pope, D., West, D.
The Promotion of dropwise Condensation by Montan Wax
11. The Composition of Montan Wax and the Mechanism of Promotion J. appl. Chem. 12, 547-552 (1962)
[4] Finnicum, S. S., Westwater, J. W.
Dropwise vs filmwise Condensation of Steam on Chromium
Int. J. Heat Mass Transfer, Vol. 32, 1541-1549 (1989)
[5] Mingdao, X., Jiliang, X.
Heat Transfer by dropwise Condensation in the two-Phase closed Thermosiphons
Proc. VIIIth Int. Heat Transfer Conf., Vol. 4, 1683-1688 (1986)

**[6]** Kast, W.

Theoretische und experimentelle Untersuchung der Wärmeübertragung bei Tropfenkondensation

Fortschrittsber. VDI, Reihe 3, Nr. 6, Düsseldorf (1965)

**[7]** Marto, P. J., Looney, D. J., Rose, J. W., Wanniarachchi, A. S.

Evaluation of organic Coatings for the Promotion of dropwise

Condensation of steam

Int. J. Heat Transfer 29,1109-1117 (1986).

**[8]** Holden, K. M., Wanniarachchi, A. S., Marto, P. J., Boone, D. H., Rose, J. W.

The Use of organic Coatings to promote dropwise Condensation of steam

Int. J. Heat Transfer 34, 768-774 (1987)

**[9]** Mori, K., Fujita, N., Horie, H., Mori, S., Miyashita, T., Matsuda, M.

Heat Transfer Promotion of an Aluminium-Brass Cooling Tube by Surface Treatment with Triazinethiols

Langmuir, Vol. 7, 1161-1166 (1991)

**[10]** Haraguchi, T., Shimada, R., Kumagal, S., Takeyama, T.

The Effecct of Polyvinylidene Chloride coating Thickness on Promotion of dropwise Steam Condensation

Int. J. Heat Mass Transfer, Vol. 34, 3047-3054 (1991)

**[11]** Utaka, Y., Saito, A., Tani, T., Shibuya, H., Katayama, K.

Study on dropwise Condensation Curves

(Measurement of Propylene Glycol Vapor on PTFE coated Surface)

Bulletin of JSME, Vol. 28, 1150-1157 (1985)

**[12]** Boyes, A. P., Ponter, A. B.

Wettability of Copper and Polyterafluorethylene Surfaces with Water - the Influence of environmental Conditions

Chemie-Ing.-Techn. 45, 1250-1256 (1973)

**[13]** Erb, R. A., Thelen, E.

Promoting permanent dropwise Condensation

Industrial and Engineering Chemistry 57, (1965)

**[14]** Cluistra, A., Oerlemans, P., Ploem, W.

Tropfenkondensation auf PTFE-haltigen galvanischen Dispersionsschichten

Firmenintemer, unveröffentlichter Bericht der Fa. AKZO-Engineering Research Laboratories Amhem, 1-26 (1976)

**[15]** Zhang, D. C., Lin, Z. Q., Lin, J. F.

New Surface Materials for dropwise Condensation

Proc. Vlilth Heat Transfer Conf. 4, 1677-1682 (1986)

**[16]** Zhao, Q., Zhang, D. C., Lin, J. F.

Surface Materials with dropwise Condensation made by Ion Implantation Technology

Int. J. Heat Mass Transfer 34, 2833-2835 (1991)

**[17]** Zhao, Q., Zhang, D. C., Zhu, X. B., Xu, D. Q., Lin, Z. Q., Lin, J. F.

Industrial Application of dropwise Condensation

Proc. IXth Int. Heat Transfer Conf., Vol. 4, 391-394 (1990)

**[18]** Bernett, M. K., Zisman, W. A.

Confirmation of Spontaneous Spreading by Water on Pure Gold

The Journal of Physikal Chemistry, Vol. 74, 2309-2312 (1970)

**[19]** Smith, T.

The hydrophilic Nature of a clean Gold Surface

J. of Colloid and Interface Science, Vol. 75, 51-55 (1980)

**[20]** Wilkins, D. G., Bromley, L. A., Read, S. M.

Dropwise and filmwise Condensation of Water Vapor on Gold

AIChE Joumal, Vol. 19, 119-123 (1973)

**[21]** Tanasawa, I., Westwater, J. W.

What we don't know about the Mechanism of dropwise Condensation

Proc. Vth Int. Heat Transfer Conf., Vol. 7,186-191 (1974)

**[22]** Woodruff, D. W., Westwater, J. W.

Steam Condensation on various Gold Surfaces

Journal of Heat Transfer, Vol. 103, 685-692 (1981)

**[23]** Barthau, G.

Dropwise Condensation of Steam - an experimental Study

Proc. of Int. Symp. on Phase Change Heat Transfer, 328-333 (1988)

**[24]** O'Neill, G. A., Westwater, J. W.

Dropwise Condensatlon of Steam on electroplated Silver Surfaces

Int. J. Heat Mass Transfer, Vol. 27,1539-1549 (1984)
[25] Hollinderbäumer, E. W., Seewald, H.
Anbackungen und Ablagerungen feuchter Schüttgüter
Chem.-Ing.-Techn. 68, 127-130 (1996)

**Patentansprüche**

1. Verwendung von Plasmapolymer-Schichtenfolgen, die als Hartstoffschicht auf Substraten, mit einer Oberschicht als Funktionsschicht sowie gegebenenfalls einer Zwischenschicht und einer Gradientenschicht, wobei die Oberschicht zur Einstellung eines definierten Benetzungsverhaltens neben den Basiselementen Kohlenstoff und Wasserstoff noch nichtmetallische bzw. halbmetallische Elemente der 3., 4., 5., 6., und/oder 7, Hauptgruppe des Periodensystems der Elemente enthält, und die über herkömmliche PVD- oder CVD-Verfahren, z.B. einen Plasma-Enhanced-Chemical-Vapor-Deposition (PECVD)-Prozeß hertelibar sind, als Funktionsschicht im Kondensatoren wobei die Funktionsschicht zur Erzwingung der Tropfes eingesetzt wird und auf das Grundmaterial der Funktionsflächen des Kondensators aufgebracht ist und diese nur eine Teilbeschichtung darstellt, bei der je nach konkretem Anwendungsfall ganz gezielt nur bestimmte Teilbereiche beschichtet sind.

2. Verwendung nach Anspruch 1, **dadurch gekennzeichnet, daß** zur Verwendung der Plasmapolymer-Schichtenfolge als Funktionsschicht in Kondensatoren die Oberschicht neben den Basiselementen Kohlenstoff und Wasserstoff 1at-% bis 70at-% bezogen auf den Kohlenstoffgehalt der nichtmetallischen bzw. halbmetallischen Elemente der 3., 4., 5., 6., und/oder 7, Hauptgruppe des Periodensystems der Elemente enthält.

3. Verwendung nach Anspruch 1 oder 2, **dadurch gekennzeichnet, daß** zur Verwendung der Plasmapolymer-Schichtenfolge als Funktionsschicht in Kondensatoren die Oberschicht neben den Basiselementen Kohlenstoff und Wasserstoff Fluor, Bor, Silicium, Stickstoff und/oder Sauerstoff enthält.

4. Verwendung nach einem oder mehreren der Ansprüche 1 bis 3, **gekennzeichnet durch** ihre Verwendung als Funktionsschicht auf Kondensatoren, wenn zur Erzwingung der Tropfenkondensation die Oberschicht eine Zusammensetzung von 1 - 40 at% F, Si und/oder O, 60 - 99 at% C, Rest Wasserstoff (bis max. 30 at%) hat.

**Claims**

1. Use of plasma polymer layer sequences which can be produced as a hard material layer on substrates, with a top layer as functional layer and also possibly with an intermediate layer and a gradient layer, the top layer containing, in addition to the base elements carbon and hydrogen, also non-metallic or semi-metallic elements of the 3rd, 4th, 5th, 6th and/or 7th main group of the periodic table of the elements in order to set a defined wetting behaviour and which can be produced, via conventional PVD- or CVD methods, e.g. a Plasma-Enhanced-Chemical-Vapour-Deposition (PECVD) process, as functional layer in condensers, the functional layer being used in order to force dropwise condensation and being applied on the base material of the functional surfaces of the condenser and said layer representing only a partial coating in which only certain partial regions are coated quite specifically according to each concrete application case.

2. Use according to claim 1, **characterised in that** for use of the plasma polymer layer sequence as functional layer in condensers, the top layer contains, in addition to the base elements carbon and hydrogen, 1 at% to 70 at% of the non-metallic or semi-metallic elements of the 3rd, 4th, 5th, 6th and/or 7th main group of the periodic table of the elements relative to the carbon content.

3. Use according to claim 1 or 2, **characterised in that** for use of the plasma polymer layer sequence as functional layer in condensers, the top layer contains, in addition to the base elements carbon and hydrogen, fluorine, boron, silicon, nitrogen and/or oxygen.

4. Use according to one or more of the claims 1 to 3, **characterised by** its use as functional layer on condensers when, in order to force dropwise condensation, the top layer has a composition of 1 - 40 at% F, Si and/or O, 60 - 99 at% C, residual hydrogen (up to max. 30 at %).

**Revendications**

1. Utilisation de séries de couches polymères plasmiques comme couche de matériau dur sur des substrats, avec une couche supérieure en tant que couche fonctionnelle ainsi qu'éventuellement avec une couche intermédiaire et une douche de gradient, dans lesquelles la couche supérieure pour l'ajustement d'un comportement défini à l'utilisation contient à côté des éléments de base carbone et hydrogène, encore des éléments non métalliques ou semi-métalliques des 3ème, 4ème, 5ème, 6ème et/ou 7ème groupes principaux du système périodique des éléments, et qui peuvent être préparées par des procédés PVD ou CVD traditionnels, par exemple par dépôt chimique sous vapeur augmenté par plasma [Plasma-Enhanced-Chemical-Vapor-Deposition (PECVD)], en tant que couche fonctionnelle dans des condenseurs, la couche fonctionnelle étant introduite pour forcer la condensation en gouttelettes et appliquée sur le matériau de base des surfaces fonctionnelles des condensateurs, et ne représentant qu'un revêtement partiel, dans lequel selon le cas concret d'application seulement des zones partielles déterminées sont revêtues d'une manière tout à fait ciblée.

2. Utilisation selon la revendication 1,
   **caractérisée en ce que**
   pour l'utilisation de la série de couches de polymères plasmiques comme couche fonctionnelle dans des condenseurs, la couche supérieure contient à côté des éléments de base carbone et hydrogène, par rapport à la teneur en carbone, 1 % à 70 % d'atomes des éléments non métalliques ou semi-métalliques 3ème, 4ème, 5ème, 6ème et/ou 7ème groupes principaux du système périodique des éléments.

3. Utilisation selon la revendication 1 ou 2,
   **caractérisée en ce que**
   pour l'utilisation de la série de couches de polymères plasmiques comme couche fonctionnelle dans des condenseurs, la couche supérieure contient à côté des éléments de base carbone et hydrogène, du fluor, du bore, du silicium, de l'azote et/ou de l'oxygène.

4. Utilisation selon l'une ou plusieurs des revendications 1 à 3,
   **caractérisée par**
   leur utilisation comme couche fonctionnelle sur des condenseurs, lorsque pour l'obtention forcée de la condensation en gouttes, la couche supérieure a une composition de 1 à 40 % at de F, Si et/ou C, 60 à 99 % at de C, le reste étant de l'hydrogène (jusqu'à un maximum de 30 % at).

Bild *A*    Erscheinungsbild der Tropfenkondensation in den eigenen Versuchen
(Fotografie mit Ausschnittsvergrößerung)

Bild **2**    Schematische Darstellung des Grundaufbaus für wärmetechnische Messungen im Vorgang der Kondensation

$S_{1-2}$

$S_{WD1}$

$S_{2WKW}$

Isolation
(PTFE)

Ø 60

Ø 68

Ø 90

≈ 10

PTFE-ummantelter
Dichtring

Bild 3     Kondensatorscheibe mit Isolationsmantel (Maße in mm)

Bild 4    Aus den Versuchen ermittelter Zusammenhang von Wärme-
          stromdichte und Wandunterkühlung (Wassersattdampf bei
          Umgebungsdruck p ≈ 1 bar)

Bild 5    Erscheinungsbild der über Teilbeschichtung definiert
          erzwungenen Mischkondensation an der Scheibe TB 7

**BILD 6**

Wärmestrom über Kühlwasservolumenstrom für die vollkommen
beschichtet Scheibe und für unterschiedliche Teilbeschichtungen,
gemessen mit Einzelstrahl und konstantem Wandabstand